(19) Europäisches Patentamt

European Patent Office

Office européen des brevets

(11) **EP 1 477 862 A2**

(12) **EUROPEAN PATENT APPLICATION**

(43) Date of publication:
**17.11.2004 Bulletin 2004/47**

(51) Int Cl.⁷: **G03F 9/00**

(21) Application number: **04252825.7**

(22) Date of filing: **14.05.2004**

(84) Designated Contracting States:
**AT BE BG CH CY CZ DE DK EE ES FI FR GB GR HU IE IT LI LU MC NL PL PT RO SE SI SK TR**
Designated Extension States:
**AL HR LT LV MK**

(30) Priority: **16.05.2003 EP 03253058**

(71) Applicant: **ASML Netherlands B.V.**
**5504 DR Veldhoven (NL)**

(72) Inventors:
• **Van Buel, Henricus Wilhelmus Maria**
  **5612 EE Eindhoven (NL)**

• **Gui, Cheng-Qun**
  **5685 AZ Best (NL)**
• **De Vries, Alex**
  **5864 AR Meerlo (NL)**

(74) Representative: **Leeming, John Gerard**
**J.A. Kemp & Co.,**
**14 South Square,**
**Gray's Inn**
**London WC1R 5JJ (GB)**

(54) **A method of calibrating a lithographic apparatus, an alignment method, a computer program, a lithographic apparatus and a device manufacturing method**

(57) A method of compensating for the distortion of front-to-backside alignment optics in which displacement vector between the estimated position of a substrate mark and the actual position of a substrate mark is calculated. An optical correction array is also calculated by moving a reference substrate by a fixed amount and comparing how far an image of a point on the back side of a reference substrate moves to how far a corresponding point on the front side of the substrate moves. The displacement vector and optical correction array are then used to accurately calculate the position of further substrates.

The front-to-backside alignment optics may be sufficiently large to simultaneously project a plurality of marks through each branch. A reference mark is implanted in the object window of the front-to-backside alignment optics and a relative change in the position of the images of the reference mark and substrate mark projected through a single branch of the front-to-backside alignment optics can indicate a change in the optical characteristics of the front-to-backside alignment optics.

Fig. 2

EP 1 477 862 A2

**Description**

The present invention relates to a lithographic projection apparatus comprising:

- a radiation system for supplying a projection beam of radiation;
- a support structure for supporting patterning means, the patterning means serving to pattern the projection beam according to a desired pattern;
- a substrate table for holding a substrate;
- a projection system for projecting the patterned beam onto a target portion of the substrate; and
- an alignment system for detecting alignment between a reference mark and said substrate mark using an alignment beam of radiation and front-to-backside alignment optics.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:

- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired.
- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-addressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096, which are incorporated herein by reference. In the case of a programmable mirror array, the said support structure may be embodied as a frame or table, for example, which may be fixed or movable as required.
- A programmable LCD array. An example of such a construction is given in United States Patent US 5,229,872, which is incorporated herein by reference. As above, the support structure in this case may be embodied as a frame or table, for example, which may be fixed or movable as required.

For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (e.g. comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper. In an alternative apparatus -commonly referred to as a step-and-scan apparatus - each target portion is irradiated by progressively scanning the mask pattern under the projection beam in a given reference direction (the "scanning" direction) while synchronously scanning the substrate table parallel or anti-parallel to this direction;

since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792, incorporated herein by reference.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4, incorporated herein by reference.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791, incorporated herein by reference.

Before exposing the substrate, it must be correctly aligned to ensure accurate projection of the functional features. A mark is provided on the substrate and detected with an alignment system. Examples of alignment systems are a conventional through the lens alignment system and also the alignment methods and apparatus described in co-pending applications EP02251440 and EP02250235. The mark is commonly on the front side of the substrate, but can also be on the back side of the substrate. Marks on the back side of the substrate are used particularly in the manufacture of Micro Electro Mechanical Systems (MEMS) or Micro Opto- Electro Mechanical Systems (MOEMS). If marks on the back side of a substrate are used, front-to-backside alignment (FTBA) optics project the mark on the back side of the substrate to the front side. Alternatively, if the marks on the front side of the substrate are no longer usable due to, for example, chemical mechanical polishing, epitaxial layer deposition or thick grainy metal layer deposition, back-to-backside alignment (BTBA) optics can be used. As there is little space for the FTBA and BTBA optics, simple optics, such as mirrors embedded in the substrate table are used. While the advantage is that these optics are cheap, the consequent disadvantage is that the optics have a low accuracy and distortion and displacement of the image of the mark is therefore common. This distortion and displacement also depends on the position of the mark on the substrate. This distortion can be compensated for by calculating displacement vectors **(ITO)** between actual positions of the substrate and estimated positions of the substrate mark for each point using, for example, a reference substrate. To calculate such displacement vectors the reference substrate should have marks on both the front and back side, although the marks need not have a direct correspondence. However, this method is difficult to implement due to the large number of ITO vectors involved. Additionally it is difficult to determine each ITO accurately.

Present methods for calibrating front-to-backside alignment optics also assume that the characteristics of the front-to-backside alignment optics do not change significantly over time. If, for example, the position of the front-to-backside alignment optics within the substrate table changed or the dimensions of the front-to-backside alignment optics changed over time this would not be accounted for in present calibration methods resulting in inaccurate alignment and inaccurate exposures. Furthermore the use of a calibration substrate disturbs the substrate throughput.

It is an object of the present invention to provide an improved method of calculating the distortion of the substrate image.

This and other objects are achieved according to the invention in a method of calibrating a lithographic apparatus comprising front-to-backside alignment optics using marks on the front and back sides of a reference substrate, the method comprising:

- calculating a displacement vector between the position of a mark on the back side of said reference substrate observed through front-to-backside alignment optics and the actual position of said mark;

- moving said reference substrate a small distance relative to said front-to-backside alignment optics and comparing how far an image of a point on the back side of said reference substrate moves to how far a point on the front side of said reference substrate moves to generate a first correction vector; and
- repeating said step of moving said reference substrate for a different point on said reference substrate to generate a second correction vector;

whereby the displacement vector and the optical correction vectors are calibration information.

This method therefore only necessitates the calculation of a single ITO vector. As only one displacement vector needs to be calculated it can be done with more accuracy. The step of repeating said step of moving said reference substrate is preferably repeated a plurality of times to generate a plurality of second correction vectors and an optical correction array thus generated. At least four optical corrections vectors should preferably be calculated.

For simpler calculation the first correction vector is subtracted from each second correction vector to normalize the optical correction array. Additionally or alternatively, in said step of moving said reference substrate and generating a correction vector the displacement vector between the image of a point on the back side of said reference substrate and said point on the front side of the reference substrate is subtracted from said correction vector. In a preferred method in said step of moving said reference substrate and calculating a correction vector the position of a point on the front side of the reference substrate corresponding to the point on the back side of the reference substrate is used.

The actual position of said mark on the back side of said reference substrate can be calculated using the measured position of a mark on the front side of said reference substrate.

According to a further aspect of the invention there is provided a method of calibrating lithographic apparatus comprising front-to-backside alignment optics using a plurality of marks, the plurality of marks being arranged to be observed through a single branch of said front-to-backside alignment optics, the method comprising:

- calculating a displacement vector between the image observed in the image window of said front-to-backside alignment optics and said mark for each of said plurality of marks; and
- recalculating at a later time a displacement vector between the image observed in the image window of said front-to-backside alignment optics and said marks each of said plurality of marks.

The recalculation of the displacement vector will thus detect any change in the front-to-backside alignment optics e.g. a change in location, dimensions or magnification of the front-to-backside alignment optics. A plurality of marks is projected through each branch of said front-to-backside alignment optics resulting in more detailed information regarding the front-to-backside alignment optics. The more marks that are projected through each branch of the front-to-backside alignment optics the more detailed the information. There is preferably also a mark implanted in the front-to-backside alignment optics. The relative position of the image (projected through the front-to-backside alignment optics) of marks arranged on the substrate and the image of the implanted mark may change, which would indicate a change in the location of the front-to-backside alignment optics relative to the substrate. Alternatively, if there is no change in the relative position of the image of the substrate marks and the image of the implanted mark there may be a change in the dimensions or magnification of the front-to-backside alignment optics. A reference substrate having a plurality of (substrate) marks on the back side may be used for the calibration.

According to a further aspect of the invention there is provided an alignment method comprising:

- providing a substrate with a substrate mark on the back side of said substrate;
- providing an alignment beam of radiation;
- providing an alignment system for projecting said alignment beam of radiation onto the substrate mark and detecting said substrate mark;

characterized in that the position of the substrate mark is calculated using a displacement vector and a plurality of correction vectors.

There should preferably be a single, rather than a plurality of displacement vectors used in this method. The method may further comprise providing front-to-backside alignment optics for projecting an image of said substrate mark on the back side of said substrate to the front side of said substrate, wherein said alignment system uses said image.

According to a further aspect of the invention there is provided an alignment method comprising:

- providing a substrate with a substrate mark on the backside of said substrate;
- providing optics for projecting an image of said substrate mark to the front side of said substrate;
- providing a mark in said optics;
- providing an alignment beam of radiation;
- providing an alignment system for projecting said alignment beam of radiation onto said marks and detecting said marks,

wherein the change in position of said detected substrate marks and said mark indicate a change in said optics.

There are preferably a plurality of substrate marks. The more substrate marks there are, the more detailed and accurate analysis of the optics can be carried out. The method may also comprise providing a reference substrate having a reference substrate mark, detecting the location of said mark and said reference substrate mark through the optics using the alignment system. The reference substrate is thus used for an initial calibration. The optics preferably include an implanted reference mark in the object window of the optics, which is used as a reference against which to measure relative changes. The optics are preferably front-to-backside alignment optics and a plurality of marks (either a plurality of substrate marks or the implanted reference mark and at least one substrate mark) are projected through each branch of the front-to-backside alignment optics.

According to a further aspect of the invention there is provided a device manufacturing method comprising:

- at least partially covering a substrate with a layer of radiation-sensitive material;
- providing a projection beam of radiation using a radiation system;
- using patterning means to endow the projection beam with a pattern in its cross-section;
- projecting the patterned beam of radiation onto a target portion of the layer of radiation-sensitive material; and
- an alignment method as described above.

The invention also provides a computer program comprising program code means that, when executed on a computer system connected to a lithographic apparatus instructs a computer system to carry out the steps described above.

According to a further aspect of the invention there is provided a lithographic projection apparatus as specified in the opening paragraph, characterized in that it further comprises:

- storage means for storing a displacement vector and a plurality of correction vectors; and
- correction means for correcting an alignment error of the substrate.

According to a further aspect of the invention there is provided a lithographic projection apparatus as specified in the opening paragraph, further comprising front-to-backside alignment optics for projecting an image of the substrate mark to the front side of the substrate wherein the front-to-backside alignment optics are sufficiently large to simultaneously project a plurality of marks including the substrate mark.

The front-to-backside alignment optics preferably have a mark implanted in the object window which is projected, together with the substrate mark through the front-to-backside alignment optics. The image in the image plane of the front-to-backside alignment optics thus comprises an image of the implanted mark and an image of the substrate mark. These images are used for the alignment.

The front-to-backside alignment optics preferably project an area of approximately 5 mm$^2$. For example, the object window may be of circular shape with a diameter of 1.2mm or rectangular, with sides of 1.4mm and 3mm.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range 5-20 nm), as well as particle beams, such as ion beams or electron beams.

Embodiments of the invention will now be described, by way of example only, with reference to the accompanying schematic drawings in which:

Figure 1 depicts a lithographic projection apparatus according to an embodiment of the invention;
Figure 2 is a diagram showing alignment of a substrate in a lithographic projection apparatus using front-to-backside alignment optics;
Figure 3 is a diagram showing the apparatus involved in the calculation of a displacement vector and an optical correction array;
Figure 4a shows the movement of marks on the front side of a reference substrate relative to an illustrative grid when calculating a correction vector;
Figure 4b shows the movement of marks on the back side of a reference substrate relative to an illustrative grid (which has also been projected through the front-to-backside alignment optics) when calculating a correction vector;
Figure 5 shows a single branch front-to-backside alignment optics with a reference mark and substrate marks;
Figure 6 shows a branch of front-to-backside alignment optics being used in detecting a shift in the optical branch of the front-to-backside alignment optics;
Figure 7 shows a branch of front-to-backside alignment optics being used in detecting a change in the dimension of the branch of the front-to-backside alignment optics; and

Figure 8 shows a branch of front-to-backside alignment optics being used in detecting a change in the optical magnification of a branch of the front-to-backside alignment optics.

In the Figures, corresponding reference symbols indicate corresponding parts.

Embodiment 1

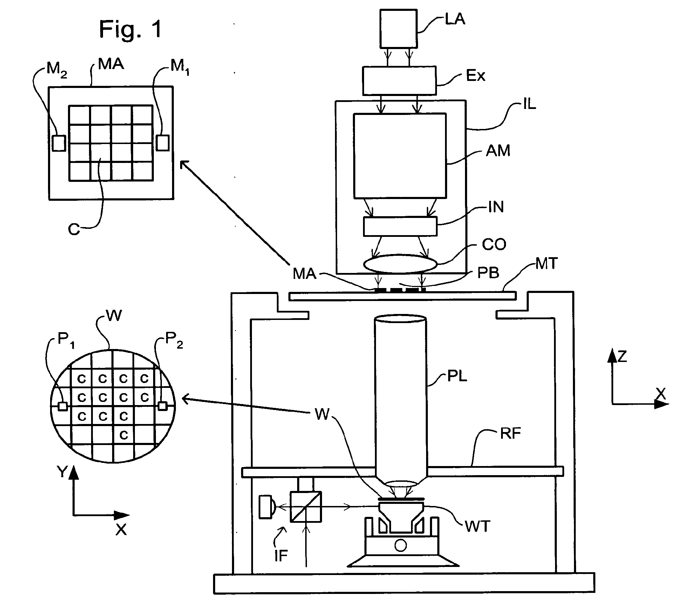

Figure 1 schematically depicts a lithographic projection apparatus according to a particular embodiment of the invention. The apparatus comprises:

· a radiation system Ex, IL, for supplying a projection beam PB of radiation (e.g. UV radiation), which in this particular case also comprises a radiation source LA;
· a first object table (mask table) MT provided with a mask holder for holding a mask MA (*e.g.* a reticle), and connected to first positioning means for accurately positioning the mask with respect to item PL;
· a second object table (substrate table) WT provided with a substrate holder for holding a substrate W (*e.g.* a resist-coated silicon wafer), and connected to second positioning means for accurately positioning the substrate with respect to item PL;
· a projection system ("lens") PL (*e.g.* a refractive lens system) for imaging an irradiated portion of the mask MA onto a target portion C (*e.g.* comprising one or more dies) of the substrate W.

As here depicted, the apparatus is of a transmissive type (*e.g.* has a transmissive mask). However, in general, it may also be of a reflective type, for example (*e.g.* with a reflective mask). Alternatively, the apparatus may employ another kind of patterning means, such as a programmable mirror array of a type as referred to above.

The source LA (*e.g.* a laser-produced or discharge plasma source) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to Figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and Claims encompass both of these scenarios.

The beam PB subsequently intercepts the mask MA, which is held on a mask table MT. Having traversed the mask MA, the beam PB passes through the lens PL, which focuses the beam PB onto a target portion C of the substrate W. With the aid of the second positioning means (and interferometric measuring means IF), the substrate table WT can be moved accurately, *e.g.* so as to position different target portions C in the path of the beam PB. Similarly, the first positioning means can be used to accurately position the mask MA with respect to the path of the beam PB, *e.g.* after mechanical retrieval of the mask MA from a mask library, or during a scan. In general, movement of the object tables MT, WT will be realized with the aid of a long-stroke module (course positioning) and a short-stroke module (fine positioning), which are not explicitly depicted in Figure 1. However, in the case of a wafer stepper (as opposed to a step-and-scan apparatus) the mask table MT may just be connected to a short stroke actuator, or may be fixed.

The depicted apparatus can be used in two different modes:

1. In step mode, the mask table MT is kept essentially stationary, and an entire mask image is projected in one go (*i.e.* a single "flash") onto a target portion C. The substrate table WT is then shifted in the x and/or y directions so that a different target portion C can be irradiated by the beam PB;
2. In scan mode, essentially the same scenario applies, except that a given target portion C is not exposed in a single "flash". Instead, the mask table MT is movable in a given direction (the so-called "scan direction", e.g. the y direction) with a speed v, so that the projection beam PB is caused to scan over a mask image; concurrently, the substrate table WT is simultaneously moved in the same or opposite direction at a speed $V = Mv$, in which $M$ is the magnification of the lens PL (typically, $M = 1/4$ or 1/5). In this manner, a relatively large target portion C can be exposed, without having to compromise on resolution.

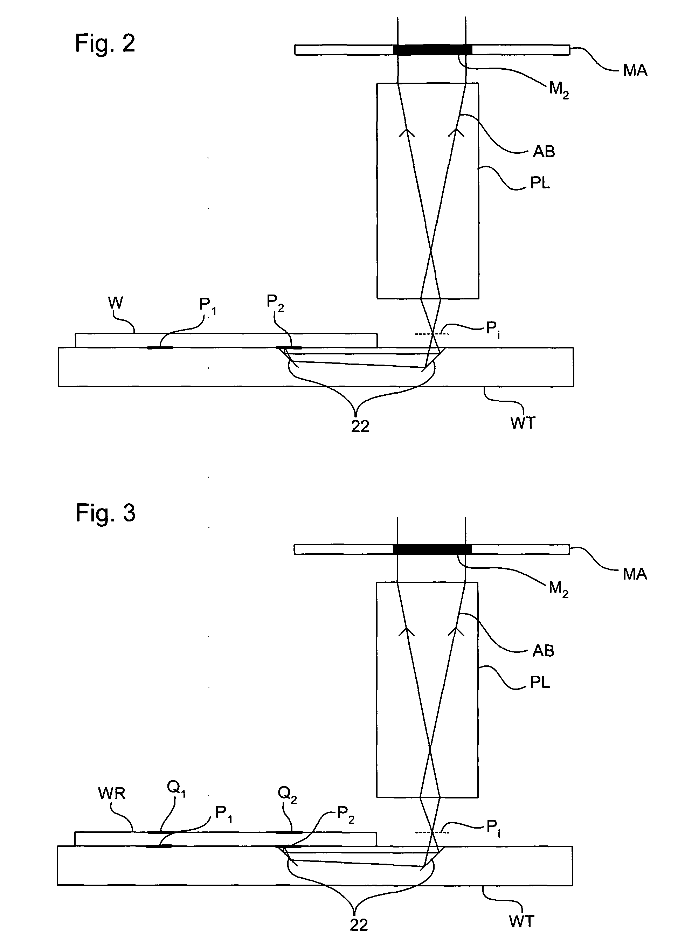

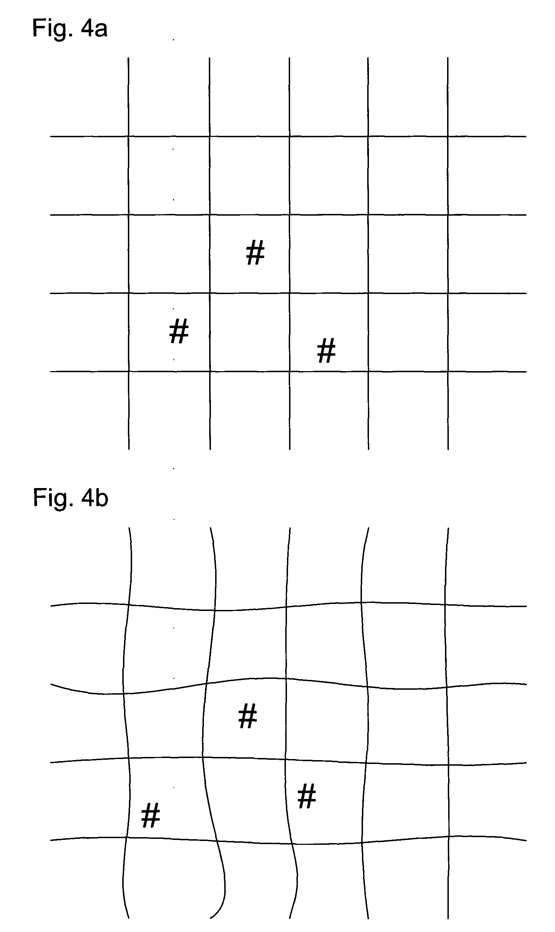

Prior to exposure of the substrate, alignment of the mask MA and substrate W takes place. Complementary alignment marks $M_1$, $M_2$ and substrate marks $P_1$, $P_2$ are present on the mask MA and substrate respectively. This invention requires no new alignment system and in Figure 2 an alignment beam AB is projected through the projection system PL. As can be seen the substrate marks $P_1$ and $P_2$ are on the back surface of the substrate and so the substrate mark $P_2$ is re-imaged by the front-to-backside alignment optics 22 at the side of the substrate W to form an image $P_i$. In Figure 4b the distortion of a grid projected through the front-to-backside alignment optics 22 is illustrated.

In Figure 3 the apparatus involved in calculating a displacement vector and an optical correction array (made up from a plurality of optical correction vectors) used to describe and compensate for the distortion are shown. For this a specially designed substrate WR having substrate marks on both the front and back side is used. The position $P_2$ of a particular substrate mark $P_2$ on the back side of the reference substrate WR is known relative to the position $Q_2$ of a substrate mark $Q_2$ on the front side of the reference substrate WR. The alignment optics described in the paragraph above are used to project an image $P_i$ of the substrate mark $P_2$ at position $P_{2i}$ and using alignment mark $M_2$ the position of $P_2$ can be estimated. An image to object vector **ITO** is the distance between the image $P_{2i}$ and the mark $P_2$, and an optical correction vector **(OCO)** indicates the relative distortion (i.e. the displacement) at different parts of the substrate. The position $P_2$ of a substrate mark on the back side of a wafer is therefore:

$$P_2 = P_{2i} + OCO + ITO \qquad (1)$$

If the front-to-backside alignment optics reflect the image this can be incorporated simply by using a transform matrix **IM.**

Using the fact that for a reference substrate the distance between the position of the mark on the front side $Q_2$ and the position of a mark on the back side $P_2$ of the reference substrate WR is known, the image to object vector ITO can be calculated for a given point:

$$ITO = (P_{2i} - Q_2) * IM - (Q_2 - P_2) \qquad (2)$$

as $(P_{2i} - Q_2)$ can be measured.

The substrate table then moves to a lifting apparatus where the reference substrate WR is lifted while the substrate table WT is moved a small distance and the reference substrate WR is then replaced on the substrate table WT. As shown in Figures 3, 4a and 4b when the substrate table WT returns to its exposing station the displacement, $Q_2$ of the reference substrate WR is ascertained (by measuring the displacement of reference mark $Q_2$). The displacement of the image of $P_2$, $P_{2i}$ (and hence the estimate of the position of $P_2$) is also measured and using the equation

$$P_2 = Q_2 + ITO + (P_{2i} + OCO - Q_2) * IM \qquad (3)$$

rearranged to

$$OCO = (P_2 - ITO - Q_2 + (Q_2 - P_{2i}) * IM) * IM^{-1} \qquad (4)$$

the optical correction vector for that position can be calculated. This is repeated for a different position on the reference substrate WR. These vectors give an indication of the relative distortion of different areas of the substrate image. Therefore the more optical correction vectors found, the more accurate the estimation of the distortion of the entire substrate image. At least four optical correction vectors should preferably be calculated. The optical correction vectors, **OCO**, are combined to form optical correction array (**OCA**). Both the displacement vector, **ITO**, and the optical correction array, **OCA** are specific to the lithographic projection apparatus, and are stored, as machine constants, for any future use of the apparatus.

For a substrate W in which the substrate marks on the front side are no longer accessible or usable, front-to-backside alignment optics are used. The position of an image of the substrate mark $P_2$ is processed to find the actual position of the substrate mark $P_2$ using the displacement vector, **ITO,** and the optical correction array, **OCA** to compensate for distortion by the front-to-backside alignment optics. The accurate position of the substrate mark $P_2$ can thus be ascertained.

For simplicity the first optical correction vector, **OCO,** can be subtracted from the second and subsequent optical correction vectors, **OCO,** to normalize the optical correction array **OCA**. Due to the smaller values, this has been found to speed up subsequent computation of the substrate position.

When using the optical correction array to align a substrate using a particular point, the nearest correction vector to the point is used. Alternatively interpolation can be used between at least two, preferably three or four of the nearest optical correction vectors, **OCO**.

This invention can furthermore be used in conjunction with a system with any number of front-to-backside alignment optic branches.

To achieve optimal results this calibration should preferably be carried out periodically.

Additionally this development can be used to compensate for distortions in the other aspects of alignment such as errors in the alignment of alignment marks.

Although a through the lens alignment system has been used to illustrate the invention, an off-axis alignment system can equally be used.

Although the invention has been illustrated using a Cartesian co-ordinate system others such as a polar co-ordinate system can be used.

Embodiment 2

This embodiment is the same as the embodiment described above except for the details given below.

This embodiment can be used in combination with the optical correction vectors described above, or using a conventional method of measuring the alignment i.e. with a plurality of image to object vectors.

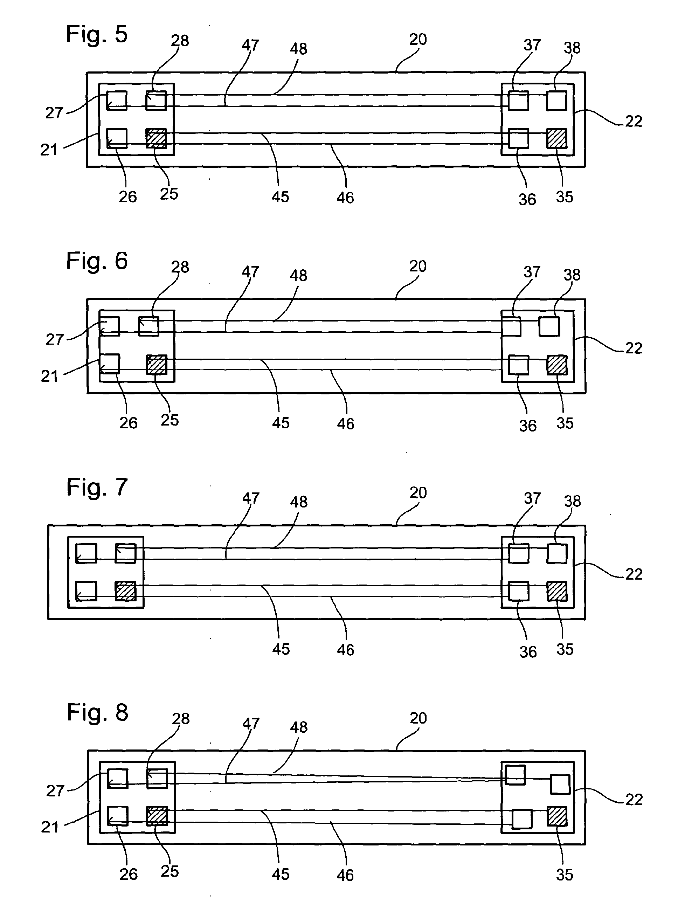

As shown in Fig. 5 each branch of the front-to-backside alignment optics 20 is sufficiently large to project at least two marks. Implanted in the object window 21 of each branch of the front-to-backside alignment optics is a reference mark 25. Reference mark 25 may be etched, marked or glued into the object window of front-to-backside alignment optics 20. Instead of a single substrate mark 26 appearing in the object window 21 of the front-to-backside alignment optics 20 three substrate marks 26, 27, 28 are in the object window of the front-to-backside alignment optics 25. As can be seen, images 35, 36, 37, 38 of the marks 25, 26, 27, 28 are projected to the image window 22 of the front-to-backside alignment optics 20. Image to object vectors, 45, 46, 47, 48 indicating the distance between the image and the mark are calculated for each mark 25, 26, 27, 28. These vectors are used as reference vectors and changes in the characteristics of the front-to-backside alignment optics are measured relative to these.

At a later time another substrate, also having substrate marks 26, 27, 28 printed in the same position on the substrate is placed on the substrate table WT. As can be seen in Fig. 6 the relative position of the image of the substrate marks 36, 37, 38 and the image of the reference mark 35 has changed. The position of the optical branch relative to the substrate W must therefore have been altered. Steps to correct this can therefore be taken.

Another scenario is depicted in Fig. 7, where all the image to object vectors have changed. This indicates that the dimensions of the branch of the front-to-backside alignment optics have been altered.

A third scenario is depicted in Fig. 8. Again, all the image to object vectors have changed. However, they have all changed by different amounts indicating that there has been a change in the magnification of this branch of the front-to-backside alignment optics 20.

Once these changes have been detected steps can be taken to compensate for them.

This method of alignment is particularly advantageous as it can be carried out using a normal substrate, no specific calibration steps are necessary. Although illustrated here using 3 substrate marks, a single substrate mark would be sufficient.

Whilst specific embodiments of the invention have been described above, it will be appreciated that the invention may be practiced otherwise than as described. The description is not intended to limit the invention.

**Claims**

1. A method of calibrating a lithographic apparatus comprising front-to-backside alignment optics using marks on the front and back sides of a reference substrate, the method comprising:

   - calculating a displacement vector between the position of a mark on the back side of said reference substrate observed through front-to-backside alignment optics and the actual position of said mark;
   - moving said reference substrate a small distance relative to said front-to-backside alignment optics and comparing how far an image of a point on the back side of said reference substrate moves to how far a point on the front side of said reference substrate moves to generate a first correction vector; and
   - repeating said step of moving said reference substrate for a different point on said reference substrate to generate a second correction vector;

   whereby the displacement vector and the optical correction vectors are calibration information.

2. A method according to claim 1 wherein step of repeating said step of moving said reference substrate is repeated a plurality of times to generate a plurality of second correction vectors and an optical correction array is generated from the correction vectors.

3. A method according to claim 2 wherein the first correction vector is subtracted from each second correction vector to normalize the optical correction array.

4. A method according to any one of the preceding claims wherein in said step of moving said reference substrate and generating a correction vector the displacement vector between the image of a point on the back side of said reference substrate and said point on the front side of the reference substrate is subtracted from said correction vector.

5. A method according to any one of the preceding claims wherein in said step of moving said reference substrate and calculating a correction vector the position of a point on the front side of the reference substrate corresponding to the point on the back side of the reference substrate is used.

6. A method according to any one of the preceding claims wherein the actual position of said mark on the back side of said reference substrate is calculated using the measured position of a mark on the front side of said reference substrate.

7. A method according to any one of claims 2 to 6 wherein at least four optical correction vectors are generated.

8. A method of calibrating lithographic apparatus comprising front-to-backside alignment optics using a plurality of marks, the plurality of marks being arranged to be observed through a single branch of said front-to-backside alignment optics, the method comprising:

   - determining a displacement vector between the image observed in the image window of said front-to-backside alignment optics and each said mark for each of said plurality of marks; and

   repeating said determining at a later time and comparing the first and later determined displacement vectors to detect any change in the font-to-backside alignment optics.

9. A method according to claim 8 wherein one of said plurality of marks is fixed within said front-to-backside alignment optics.

10. A method according to either claim 8 or claim 9 wherein at least one said plurality of marks is on the backside of a reference substrate.

11. A method according to any one of claims 8 to 10 wherein said calculations are used to determine a shift in the optical branch.

12. A method according to any one of claims 8 to 11 wherein said calculations are used to determine a change in dimensions of said front-to-backside alignment optics.

13. A method according to any one of claims 8 to 12 wherein said calculations are used to determine a change in the optical magnification of said front-to-backside alignment optics.

14. An alignment method comprising:

   - providing a substrate with a substrate mark on the back side of said substrate;
   - providing an alignment beam of radiation;
   - providing an alignment system for projecting said alignment beam of radiation onto the substrate mark and detecting said substrate mark;

   **characterized in that** the position of the substrate mark is calculated using a displacement vector and a plurality of correction vectors.

15. An alignment method according to claim 14 further comprising providing front-to-backside alignment optics for projecting an image of said substrate mark on the back side of said substrate to the front side of said substrate and said alignment system uses said image.

16. A device manufacturing method comprising the steps of:

   - at least partially covering a substrate with a layer of radiation-sensitive material;
   - providing a projection beam of radiation using a radiation system;
   - using patterning means to endow the projection beam with a pattern in its cross-section;
   - projecting the patterned beam of radiation onto a target portion of the layer of radiation-sensitive material; and
   - an alignment method according to either claim 14 or claim 15.

17. A device manufactured according to claim 16.

18. A computer program comprising program code means that, when executed on a computer system instructs a computer system connected to a lithographic apparatus to carry out the steps according to any one of claims 1 to 17.

19. A lithographic projection apparatus comprising:

   - a radiation system for providing a projection beam of radiation;
   - a support structure for supporting patterning means, the patterning means serving to pattern the projection beam according to a desired pattern;
   - a substrate table for holding a substrate;
   - a projection system for projection the patterned beam onto a target portion of the substrate;
   - an alignment system for detecting alignment between a reference mark and said substrate mark using an alignment beam of radiation and front-to-backside alignment optics;

   **characterized in that** it further comprises:

   - storage means for storing a displacement vector and a plurality of correction vectors; and
   - correction means for correcting an alignment error of the substrate.

20. A lithographic projection apparatus comprising:

   - a radiation system for providing a projection beam of radiation;
   - a support structure for supporting patterning means, the patterning means serving to pattern the projection beam according to a desired pattern;

- a substrate table for holding a substrate having a substrate mark on its backside;
- a projection system for projection the patterned beam onto a target portion of the substrate;
- front-to-backside alignment optics for projecting an image of said substrate mark to the front side of said substrate; and
- an alignment system for detecting alignment between a reference mark and said substrate mark using an alignment beam of radiation and said front-to-backside alignment optics,

wherein said front-to-backside alignment optics are sufficiently large to simultaneously project a plurality of marks including said substrate mark.

21. A lithographic apparatus according to claim 20 wherein said front-to-backside alignment optics have a mark implanted which is projected, together with said substrate mark, through said front-to-backside alignment optics.

22. A lithographic projection apparatus wherein the object window of the front-to-backside alignment optics has a diameter of at least 1mm.

## Fig. 1

Fig. 2

Fig. 3

Fig. 4a

Fig. 4b

**Fig. 5**

**Fig. 6**

**Fig. 7**

**Fig. 8**